# EUROPEAN PATENT APPLICATION

(11) **EP 4 832 256 A1**
(43) Date of publication of application: **28.10.2026**
(21) Application number: 26170351.6
(22) Date of filing: 01.04.2026
(51) Int. Cl.: H01R 12/79, H01R 12/72, H05K 1/02, H05K 1/11, H05K 1/14, H01R 12/70, H05K 3/46

(54) **PRINTED WIRING BOARD AND PRINTED WIRING BOARD UNIT**

(30) Priority: 11.04.2025 JP 2025065792
(71) Applicant: Kyocera Document Solutions Inc., Osaka-shi, Osaka 540-8585 (JP)
(72) Inventor: YAMAZAKI, Ayumu, Osaka,, 540-8585 (JP)
(74) Representative: BRP Renaud & Partner mbB Rechtsanwälte Patentanwälte Steuerberater

(57) **Abstract**

A board (10) has N connectors (11~13) disposed on one surface. Each N connector includes a plurality of pins (11K) arranged in one direction, the number of the pins being different among the N connectors. Each N connector is disposed such that the one direction is parallel to one side of the board. An nth connector having an nth largest number of pins among the N connectors is disposed between a straight line including one end in the one direction of an (n-1)th connector having an (n-1)th largest number of pins among the N connectors and a straight line including the other end thereof in the one direction. The N connectors are disposed such that the larger the number of pins (11K) of connectors, the closer the connector is to the one side.

## Description

### BACKGROUND

The present invention relates to a board having a planar shape and having a plurality of connectors disposed on one surface thereof, and a board unit including the board.

In recent years, due to space saving of boards and miniaturization of electronic components, it has become common that a plurality of connectors, to which a plurality of flexible flat cables (FFCs) are connected, are disposed on one surface of a single board. In addition, Patent Documents 1 and 2 disclose configurations in which a plurality of FFCs are stacked, and a plurality of such stacked FFCs are connected to a plurality of connectors disposed on one surface of a single board.

### SUMMARY

An aspect of the present invention proposes a technology further improving the foregoing technology.

A board according to an aspect of the present invention is a board having a planar shape and having N connectors (N is an integer of 2 or larger) disposed on one surface thereof. Each of the N connectors includes a plurality of pins arranged in one direction, the number of the pins being different among the N connectors. Each of the N connectors is disposed such that the one direction in which the plurality of pins are arranged is parallel to one side of the board. An nth connector having an nth largest number of pins (n is an integer of 2 to N) among the N connectors is disposed between a straight line including one end in the one direction of an (n-1)th connector having an (n-1)th largest number of pins among the N connectors and a straight line including the other end thereof in the one direction. The N connectors are disposed such that the larger the number of the pins of connectors, the closer the connector is to the one side.

A board unit according to another aspect of the present invention includes the board serving as a first board, a second board different from the first board, and a third board different from the first board and the second board. An additional connector is further disposed on the one surface of the first board. The additional connector includes a plurality of pins arranged in one direction, the number of which is greater than the number of pins of an mth connector having an mth largest number of pins (m is an integer from 1 to N) among the N connectors. The additional connector is disposed farther from the one side than the mth connector. N second board-side connectors, to which the other ends of N flexible flat cables having one ends to be connected to the N connectors are connected, are disposed on the second board. A third board-side connector, to which the other end of a flexible flat cable having one end to be connected to the additional connector is connected, is disposed on the third board.

### BRIEF DESCRIPTION OF THE DRAWINGS

FIG. 1A is a schematic plan view of a board according to a first embodiment of the present invention.
FIG. 1B is a schematic plan view of another board according to the first embodiment.
FIG. 2 is a schematic plan view of an FFC connector in FIG. 1A.
FIG. 3 is a schematic plan view of an FFC connecting the FFC connectors in FIG. 1A and connectors in FIG. 1B to each other.
FIG. 4 is a schematic view showing a connection state by the FFCs between the FFC connectors in FIG. 1A and the connectors in FIG. 1B.
FIG. 5A is a schematic plan view of a board according to a second embodiment of the present invention.
FIG. 5B is a schematic plan view of another board according to the second embodiment.
FIG. 5C is a schematic plan view of another board according to the second embodiment.
FIG. 6 is a schematic view showing a connection state by the FFCs between FFC connectors in FIG. 5A, connectors in FIG. 5B, and connectors in FIG. 5C.

### DETAILED DESCRIPTION

### <<First embodiment>>

Hereinafter, boards and a board unit according to a first embodiment of the present invention will be described with reference to the drawings.

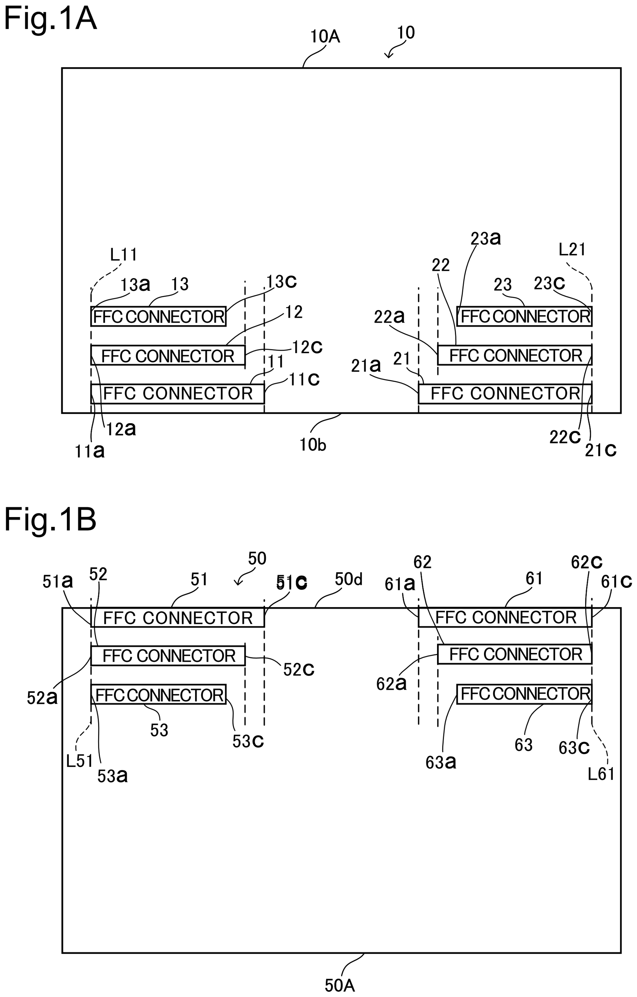

First, configurations of boards 10 and 50 according to the first embodiment of the present invention will be described with reference to FIGS. 1A and 1B. FIGS. 1A and 1B are schematic plan views of the boards 10 and 50 according to the first embodiment of the present invention.

The board 10 has a planar shape and includes, as shown in FIG. 1A, a planar printed wiring board (PWB) 10A, six connectors (which will hereinafter be referred to as "FFC connectors") 11 to 13 and 21 to 23 which are disposed on one surface of the PWB 10A and to which flexible flat cables (FFCs) are respectively connected, wirings (not shown), an integrated circuit (IC) (not shown) disposed on the one surface, and the like. For example, the PWB 10A of the board 10 is a flexible board. Three FFC connectors 11 to 13 are an example of the N connectors in the claims, and the number of FFC connectors may be 2, 4, or larger. In addition, three FFC connectors 21 to 23 are another example of the N FFC connectors in the claims, and the number of FFC connectors may be 2, 4, or larger.

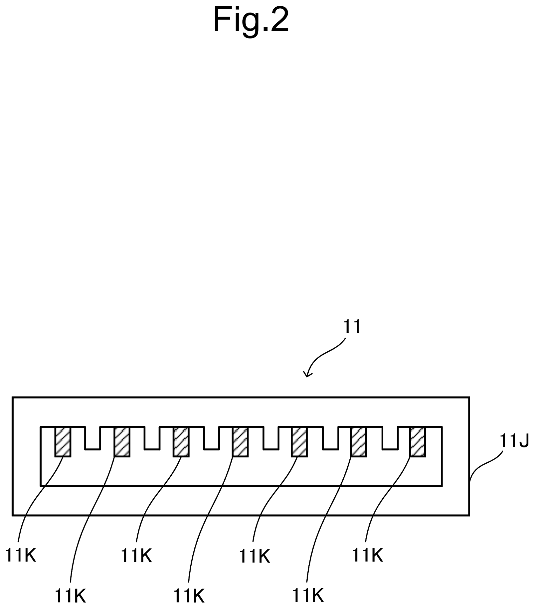

As shown in FIG. 2, the FFC connector 11 has a casing 11J made of, for example, non-conductive resin, and a plurality of (seven in FIG. 2) conductive pins 11K held by the casing 11J and arranged in one direction in a plan view. The FFC connector 11 has a rectangular shape whose length in the one direction in which the plurality of pins 11K are arranged is longer than that in a direction orthogonal to the one direction. In FIG. 2, the number of pins 11K is shown as seven, but the number of pins 11K may be any number other than seven. An FFC connector having the same number of pins as the FFC connector 11 has the same structure as the FFC connector 11, and an FFC connector having a number of pins different from the FFC connector 11 has the same structure as the FFC connector 11 except for the different number of pins.

Each of the FFC connectors 11, 12, and 13 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 11, the FFC connector 12, and the FFC connector 13 (number of pins of the FFC connector 11 > number of pins of the FFC connector 12 > number of pins of the FFC connector 13). In addition, intervals between the pins of the FFC connector 11 in the longitudinal direction, intervals between the pins of the FFC connector 12 in the longitudinal direction, and intervals between the pins of the FFC connector 13 in the longitudinal direction are the same as each other. In addition, a distance between both ends in the longitudinal direction (length of the long side) in order from largest is that of the FFC connector 11, the FFC connector 12, and the FFC connector 13.

The FFC connectors 11 to 13 are disposed such that the one direction in which the plurality of pins of the FFC connectors 11 to 13 are arranged is parallel to one side (which will hereinafter be referred to as a "first side") 10b of the board 10 (PWB 10A). The FFC connectors 11 to 13 are disposed such that the larger the number of pins of connectors, the closer the connector is to the first side 10b.

The FFC connector 12 is disposed between a straight line including one end 11a in the foregoing one direction in which the plurality of pins of the FFC connector 11 are arranged and a straight line including the other end 11c in the foregoing one direction in which the plurality of pins of the FFC connector 11 are arranged. In addition, the FFC connector 13 is disposed between a straight line including one end 12a in the foregoing one direction in which the plurality of pins of the FFC connector 12 are arranged and a straight line including the other end 12c in the foregoing one direction in which the plurality of pins of the FFC connector 12 are arranged.

In the present embodiment, the FFC connectors 11 to 13 are disposed side by side with the one ends 11a to 13a in the foregoing one direction, in which the plurality of pins of the FFC connectors 11 to 13 are arranged, on a single straight line L11 orthogonal to the first side 10b. As another case, there is a case or the like in which the FFC connectors 11 to 13 are disposed side by side with the other ends 11c to 13c in the foregoing one direction, in which the plurality of pins of the FFC connectors 11 to 13 are arranged, on a single straight line orthogonal to the first side 10b. The one ends 11a to 13a and the other ends 11c to 13c described above are orthogonal to the first side 10b.

Each of the FFC connectors 21, 22, and 23 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 21, the FFC connector 22, and the FFC connector 23 (number of pins of the FFC connector 21 > number of pins of the FFC connector 22 > number of pins of the FFC connector 23). In addition, intervals between the pins of the FFC connector 21 in the longitudinal direction, intervals between the pins of the FFC connector 22 in the longitudinal direction, and intervals between the pins of the FFC connector 23 in the longitudinal direction are the same as each other. In addition, a distance between both ends in the longitudinal direction (length of the long side) in order from largest is that of the FFC connector 21, the FFC connector 22, and the FFC connector 23.

The FFC connectors 21 to 23 are disposed such that the one direction in which the plurality of pins of the FFC connectors 21 to 23 are arranged is parallel to the first side 10b of the board 10 (PWB 10A). The FFC connectors 21 to 23 are disposed such that the larger the number of pins of connectors, the closer the connector is to the first side 10b.

The FFC connector 22 is disposed between a straight line including one end 21c in the foregoing one direction in which the plurality of pins of the FFC connector 21 are arranged and a straight line including the other end 21a in the foregoing one direction in which the plurality of pins of the FFC connector 21 are arranged. In addition, the FFC connector 23 is disposed between a straight line including one end 22c in the foregoing one direction in which the plurality of pins of the FFC connector 22 are arranged and a straight line including the other end 22a in the foregoing one direction in which the plurality of pins of the FFC connector 22 are arranged.

In the present embodiment, the FFC connectors 21 to 23 are disposed side by side with the one ends 21c to 23c in the foregoing one direction, in which the plurality of pins of the FFC connectors 21 to 23 are arranged, on a single straight line L21 orthogonal to the first side 10b. As another case, there is a case or the like in which the FFC connectors 21 to 23 are disposed side by side with the other ends 21a to 23a in the foregoing one direction, in which the plurality of pins of the FFC connectors 21 to 23 are arranged, on a single straight line orthogonal to the first side 10b. The one ends 21c to 23c and the other ends 21a to 23a described above are orthogonal to the first side 10b.

The board 50 has a planar shape and includes, as shown in FIG. 1B, a planar PWB 50A, six FFC connectors 51 to 53 and 61 to 63 which are disposed on one surface of the PWB 50A and to which FFCs are respectively connected, wirings (not shown), an IC (not shown) disposed on the one surface, and the like. For example, the PWB 50A of the board 50 is a flexible board. Three FFC connectors 51 to 53 are an example of the N connectors in the claims, and the number of FFC connectors may be 2, 4, or larger. In addition, the three FFC connectors 61 to 63 are another example of the N connectors in the claims, and the number of FFC connectors may be 2, 4, or larger.

Each of the FFC connectors 51, 52, and 53 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 51, the FFC connector 52, and the FFC connector 53 (number of pins of the FFC connector 51 > number of pins of the FFC connector 52 > number of pins of the FFC connector 53). In the present embodiment, the number of pins of the FFC connector 51 is equal to the number of pins of the FFC connector 11, the number of pins of the FFC connector 52 is equal to the number of pins of the FFC connector 12, and the number of pins of the FFC connector 53 is equal to the number of pins of the FFC connector 13. In addition, intervals between the pins of the FFC connector 51 in the longitudinal direction, intervals between the pins of the FFC connector 52 in the longitudinal direction, and intervals between the pins of the FFC connector 53 in the longitudinal direction are the same as each other. In addition, a distance between both ends in the longitudinal direction (length of the long side) in order from largest is that of the FFC connector 51, the FFC connector 52, and the FFC connector 53.

The FFC connectors 51 to 53 are disposed such that the one direction in which the plurality of pins of the FFC connectors 51 to 53 are arranged is parallel to one side (which will hereinafter be referred to as a "first side") 50d of the board 50 (PWB 50A). The FFC connectors 51 to 53 are disposed such that the larger the number of pins of connectors, the closer the connector is to the first side 50d.

The FFC connector 52 is disposed between a straight line including one end 51a in the foregoing one direction in which the plurality of pins of the FFC connector 51 are arranged and a straight line including the other end 51c in the foregoing one direction in which the plurality of pins of the FFC connector 51 are arranged. In addition, the FFC connector 53 is disposed between a straight line including one end 52a in the foregoing one direction in which the plurality of pins of the FFC connector 52 are arranged and a straight line including the other end 52c in the foregoing one direction in which the plurality of pins of the FFC connector 52 are arranged.

In the present embodiment, the FFC connectors 51 to 53 are disposed side by side with the one ends 51a to 53a in the foregoing one direction, in which the plurality of pins of the FFC connectors 51 to 53 are arranged, on a single straight line L51 orthogonal to the first side 50d. As another case, there is a case or the like in which the FFC connectors 51 to 53 are disposed side by side with the other ends 51c to 53c on a single straight line orthogonal to the first side 50d. The one ends 51a to 53a and the other ends 51c to 53c described above are orthogonal to the first side 50d.

Each of the FFC connectors 61, 62, and 63 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 61, the FFC connector 62, and the FFC connector 63 (number of pins of the FFC connector 61 > number of pins of the FFC connector 62 > number of pins of the FFC connector 63). In the present embodiment, the number of pins of the FFC connector 61 is equal to the number of pins of the FFC connector 21, the number of pins of the FFC connector 62 is equal to the number of pins of the FFC connector 22, and the number of pins of the FFC connector 63 is equal to the number of pins of the FFC connector 23. In addition, intervals between the pins of the FFC connector 61 in the longitudinal direction, intervals between the pins of the FFC connector 62 in the longitudinal direction, and intervals between the pins of the FFC connector 63 in the longitudinal direction are the same as each other. In addition, a distance between both ends in the longitudinal direction (length of the long side) in order from largest is that of the FFC connector 61, the FFC connector 62, and the FFC connector 63.

The FFC connectors 61 to 63 are disposed such that the one direction in which the plurality of pins of the FFC connectors 61 to 63 are arranged is parallel to the first side 50d of the board 50 (PWB 50A). The FFC connectors 61 to 63 are disposed such that the larger the number of pins of connectors, the closer the connector is to the first side 50d.

The FFC connector 62 is disposed between a straight line including one end 61c in the foregoing one direction in which the plurality of pins of the FFC connector 61 are arranged and a straight line including the other end 61a in the foregoing one direction in which the plurality of pins of the FFC connector 61 are arranged. In addition, the FFC connector 63 is disposed between a straight line including one end 62c in the foregoing one direction in which the plurality of pins of the FFC connector 62 are arranged and a straight line including the other end 62a in the foregoing one direction in which the plurality of pins of the FFC connector 62 are arranged.

In the present embodiment, the FFC connectors 61 to 63 are disposed side by side with the one ends 61c to 63c in the foregoing one direction, in which the plurality of pins of the FFC connectors 61 to 63 are arranged, on a single straight line L61 orthogonal to the first side 50d. As another case, there is a case or the like in which the FFC connectors 61 to 63 are disposed side by side with the other ends 61a to 63a in the foregoing one direction, in which the plurality of pins of the FFC connectors 61 to 63 are arranged, on a single straight line orthogonal to the first side 50d. The one ends 61c to 63c and the other ends 61a to 63a described above are orthogonal to the first side 50d.

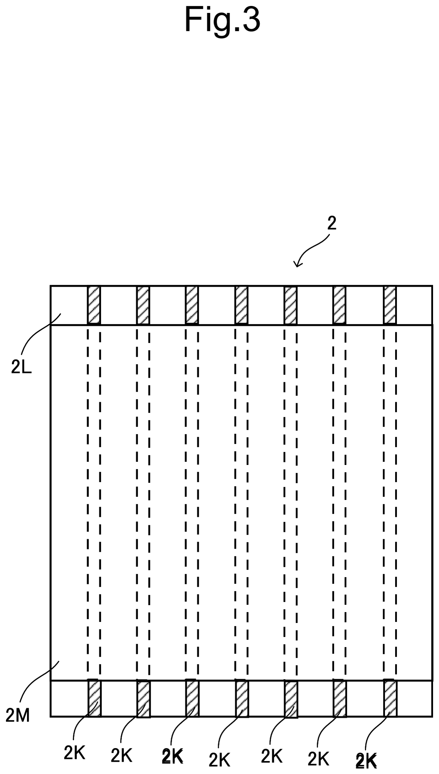

Subsequently, a structure of an FFC 2 connecting the FFC connector 11 in FIG. 1A and the FFC connector 51 in FIG. 1B to each other will be described with reference to FIG. 3. FIG. 3 is a schematic plan view of the FFC 2 connecting the FFC connector 11 in FIG. 1A and the FFC connector 51 in FIG. 1B to each other.

In a plan view, the FFC 2 has a plurality of (seven in FIG. 3) conductors 2K arranged in one direction, and resin covers 2L and 2M having no conductivity and holding the plurality of conductors 2K sandwiched therebetween. The cover 2L covers the conductors 2K from one end to the other end, and the cover 2M covers the conductors 2K from the other end side of the one end to the one end side of the other end. The conductors 2K are connected to a single FFC connector at one end not covered by the cover 2M and are connected to another FFC connector at the other end not covered by the cover 2M. An FFC having the same number of conductors as the FFC 2 has the same structure as the FFC 2, and an FFC having a number of conductors different from the FFC 2 has the same structure as the FFC 2 except for the different number of conductors.

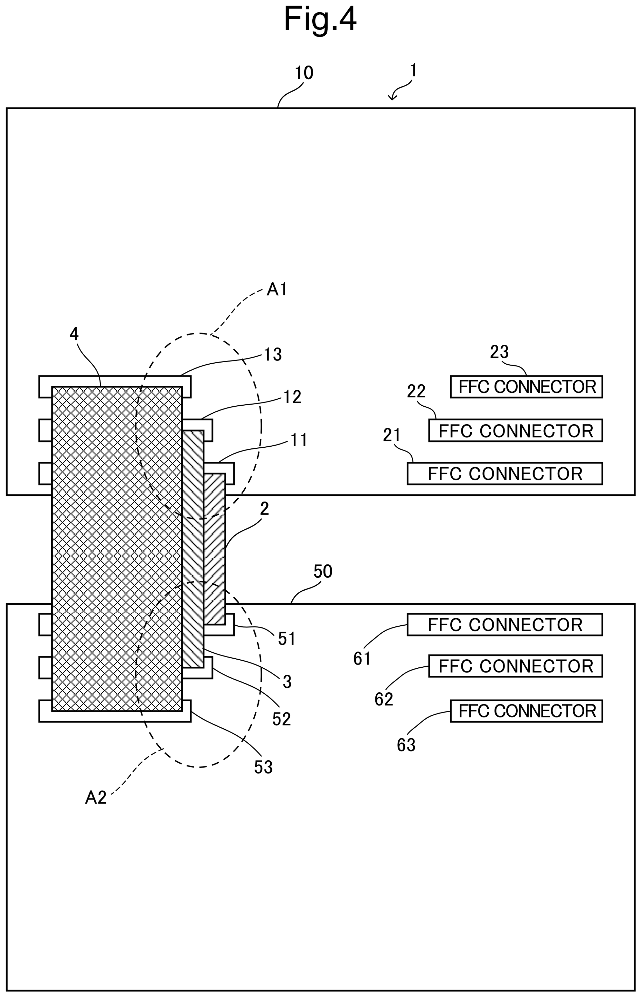

Subsequently, connection between the FFC connectors 11 to 13 of the board 10 in FIG. 1A and the FFC connectors 51 to 53 of the board 50 in FIG. 1B by the FFCs 2 to 4 will be described with reference to FIG. 4. FIG. 4 is a schematic view showing a connection state by the FFCs 2 to 4 between the FFC connectors 11 to 13 of the board 10 in FIG. 1A and the FFC connectors 51 to 53 of the board 50 in FIG. 1B.

As shown in FIG. 1A, a board unit 1 includes the board 10 on which the FFC connectors 11 to 13 and 21 to 23 are disposed on the one surface of the PWB 10A, the board 50 on which the FFC connectors 51 to 53 and 61 to 63 are disposed on the one surface of the PWB 50A, the FFCs 2 to 4 connecting the FFC connectors 11 to 13 and the FFC connectors 51 to 53 to each other, and three FFCs connecting the FFC connectors 21 to 23 and the FFC connectors 61 to 63 to each other (not shown).

The FFC 2 has the same number of conductors as the number of pins of the FFC connectors 11 and 51. In the FFC 2, one ends of the plurality of conductors of the FFC 2 are connected to the plurality of pins of the connector 11, and the other ends thereof are connected to a plurality of pins of the connector 51. An FFC 3 has the same number of conductors as the number of pins of the FFC connectors 12 and 52. In the FFC 3, one ends of the plurality of conductors of the FFC 3 are connected to a plurality of pins of the connector 12, and the other ends thereof are connected to a plurality of pins of the connector 52 so as to straddle the FFC 2. An FFC 4 has the same number of conductors as the number of pins of the FFC connectors 13 and 53. In the FFC 4, one ends of the plurality of conductors of the FFC 4 are connected to a plurality of pins of the connector 13, and the other ends thereof are connected to a plurality of pins of the connector 53 so as to straddle the FFC 3.

According to the foregoing first embodiment, in a region surrounded by a dotted line A1 in FIG. 4, a portion of a connection part between the FFC connector 11 and the FFC 2 is visually recognizable from outside without being hidden by the FFCs 3 and 4, a portion of a connection part between the FFC connector 12 and the FFC 3 is visually recognizable from outside without being hidden by the FFC 4, and the entire connection part between the FFC connector 13 and the FFC 4 is visually recognizable from outside. In addition, in a region surrounded by a dotted line A2 in FIG. 4, a portion of a connection part between the FFC connector 51 and the FFC 2 is visually recognizable from outside without being hidden by the FFCs 3 and 4, a portion of a connection part between the FFC connector 52 and the FFC 3 is visually recognizable from outside without being hidden by the FFC 4, and the entire connection part between the FFC connector 53 and the FFC 4 is visually recognizable from outside. Therefore, it is possible to improve visibility for confirming connection between the FFCs 2 to 4 and the FFC connectors 11 to 13 and 51 to 53 during connection work and after connection work of the FFCs 2 to 4 to the FFC connectors 11 to 13 and 51 to 53.

### <<Second embodiment>>

Hereinafter, boards and a board unit according to a second embodiment of the present invention will be described with reference to the drawings.

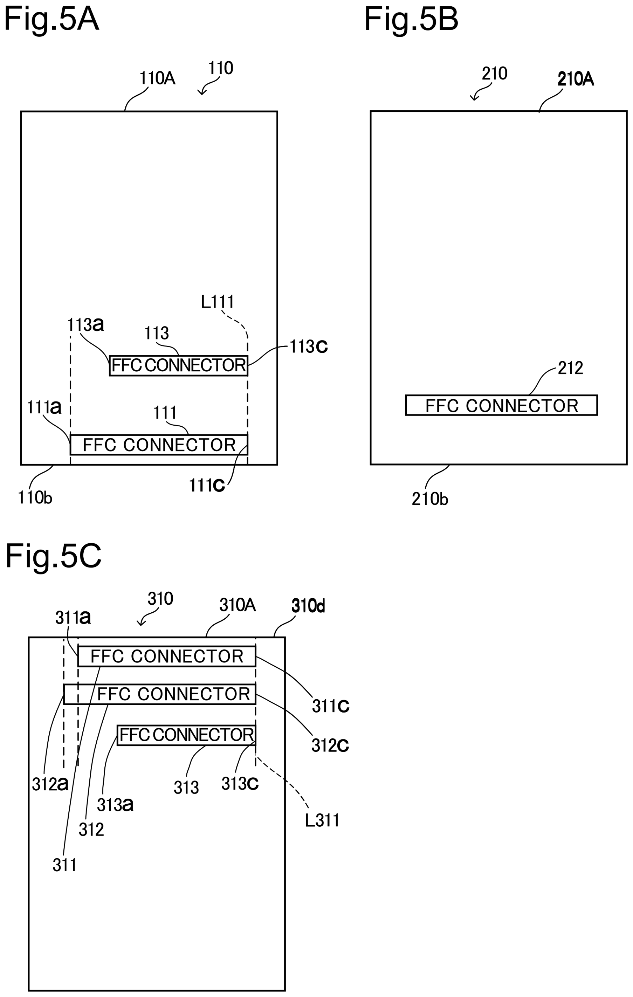

First, configurations of boards 110, 210, and 310 according to the second embodiment of the present invention will be described with reference to FIGS. 5A, 5B, and 5C. FIGS. 5A, 5B, and 5C are schematic plan views of the boards 110, 210, and 310 according to the second embodiment of the present invention.

The board 110 has a planar shape and includes, as shown in FIG. 5A, a planar PWB 110A, two FFC connectors 111 and 113 which are disposed on one surface of the PWB 110A and to which FFCs are respectively connected, wirings (not shown), an IC (not shown) disposed on the one surface, and the like. For example, the PWB 110A of the board 110 is a flexible board.

Each of the FFC connectors 111 and 113 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 111 and the FFC connector 113 (number of pins of the FFC connector 111 > number of pins of the FFC connector 113). In addition, intervals between the pins of the FFC connector 111 in the longitudinal direction, and intervals between the pins of the FFC connector 113 in the longitudinal direction are the same as each other. A distance between both ends in the longitudinal direction (length of the long side) in order from largest is that of the FFC connector 111 and the FFC connector 113.

The FFC connectors 111 and 113 are disposed such that the one direction in which the plurality of pins of the FFC connectors 111 and 113 are arranged is parallel to one side (which will hereinafter be referred to as a "first side") 110b of the board 110 (PWB 110A). The FFC connectors 111 and 113 are disposed such that the larger the number of pins of connectors, the closer the connector is to the first side 110b.

The FFC connector 113 is disposed between a straight line including one end 111c in the foregoing one direction in which the plurality of pins of the FFC connector 111 are arranged and a straight line including the other end 111a in the foregoing one direction in which the plurality of pins of the FFC connector 111 are arranged.

In the present embodiment, as a case satisfying the foregoing disposition of the FFC connectors 111 and 113, the FFC connectors 111 and 113 are disposed side by side with the one ends 111c and 113c in the foregoing one direction, in which the plurality of pins of the FFC connectors 111 and 113 are arranged, on a single straight line L111 orthogonal to the first side 110b. As another case, there is a case or the like in which the FFC connectors 111 and 113 are disposed side by side with the other ends 111a and 113a in the foregoing one direction, in which the plurality of pins of the FFC connectors 111 and 113 are arranged, on a single straight line orthogonal to the first side 110b. The one ends 111c and 113c and the other ends 111a and 113a described above are orthogonal to the first side 110b.

The board 210 has a planar shape and includes, as shown in FIG. 5B, a planar PWB 210A, one FFC connector 212 which is disposed on one surface of the PWB 210A and to which FFCs are connected, wirings (not shown), an IC (not shown) disposed on the one surface, and the like. For example, the PWB 210A of the board 210 is a flexible board.

The FFC connector 212 has a plurality of pins arranged in one direction, and has a rectangular shape whose length in the one direction in which the plurality of pins are arranged is longer than the length in a direction orthogonal to the one direction in a plan view. The FFC connector 212 is disposed such that the one direction in which the plurality of pins are arranged is parallel to one side (which will hereinafter be referred to as a "first side") 210b of the board 210 (PWB 210A).

The board 310 has a planar shape and includes, as shown in FIG. 5C, a planar PWB 310A, three FFC connectors 311 to 313 which are disposed on one surface of the PWB 310A and to which an FFC is connected, wirings (not shown), an IC (not shown) disposed on the one surface, and the like. For example, the PWB 310A of the board 310 is a flexible board.

Each of the FFC connectors 311, 312, and 313 has a plurality of pins arranged in one direction, and has a rectangular shape whose length in the one direction in which the plurality of pins are arranged is longer than the length in a direction orthogonal to the one direction in a plan view. The number of pins in order from largest is that of the FFC connector 312, the FFC connector 311, and the FFC connector 313 (number of pins of the FFC connector 312 > number of pins of the FFC connector 311 > number of pins of the FFC connector 313). In the present embodiment, the number of pins of the FFC connector 311 is equal to the number of pins of the FFC connector 111, the number of pins of the FFC connector 312 is equal to the number of pins of the FFC connector 212, and the number of pins of the FFC connector 313 is equal to the number of pins of the FFC connector 113. In addition, intervals between the pins of the FFC connector 311 in the longitudinal direction, intervals between the pins of the FFC connector 312 in the longitudinal direction, and intervals between the pins included in the FFC connector 313 in the longitudinal direction are the same as each other. In addition, a distance between both ends in the longitudinal direction (length of the long side) in order from largest is that of the FFC connector 312, the FFC connector 311, and the FFC connector 313.

The FFC connectors 311 to 313 are disposed such that the one direction in which the plurality of pins of the FFC connectors 311 to 313 are arranged is parallel to one side (which will hereinafter be referred to as a "first side") 310d of the board 310 (PWB 310A). The FFC connectors 311 and 313 are disposed such that the larger the number of pins of connectors, the closer the connector is to the first side 310d. In addition, the FFC connector 312 is disposed farther from the first side 310d than the FFC connector 311 and is disposed closer to the first side 310d than the FFC connector 313.

The FFC connector 311 is disposed between a straight line including one end 312c in the foregoing one direction in which the plurality of pins of the FFC connector 312 are arranged and a straight line including the other end 312a in the foregoing one direction in which the plurality of pins of the FFC connector 312 are arranged. In addition, the FFC connector 313 is disposed between a straight line including one end 311c in the foregoing one direction in which the plurality of pins of the FFC connector 311 are arranged and a straight line including the other end 311a in the foregoing one direction in which the plurality of pins of the FFC connector 311 are arranged.

In the present embodiment, as a case satisfying the foregoing disposition of the FFC connectors 311 to 313, the FFC connectors 311 to 313 are disposed side by side with the one ends 311c to 313c in the foregoing one direction, in which the plurality of pins of the FFC connectors 311 to 313 are arranged, on a single straight line L311 orthogonal to the first side 310d. As another case, there is a case or the like in which the FFC connectors 311 to 313 are disposed side by side with the other ends 311a to 313a in the foregoing one direction, in which the plurality of pins of the FFC connectors 311 to 313 are arranged, on a single straight line orthogonal to the first side 310d. The one ends 311c to 313c and the other ends 311a to 313a described above are orthogonal to the first side 310d.

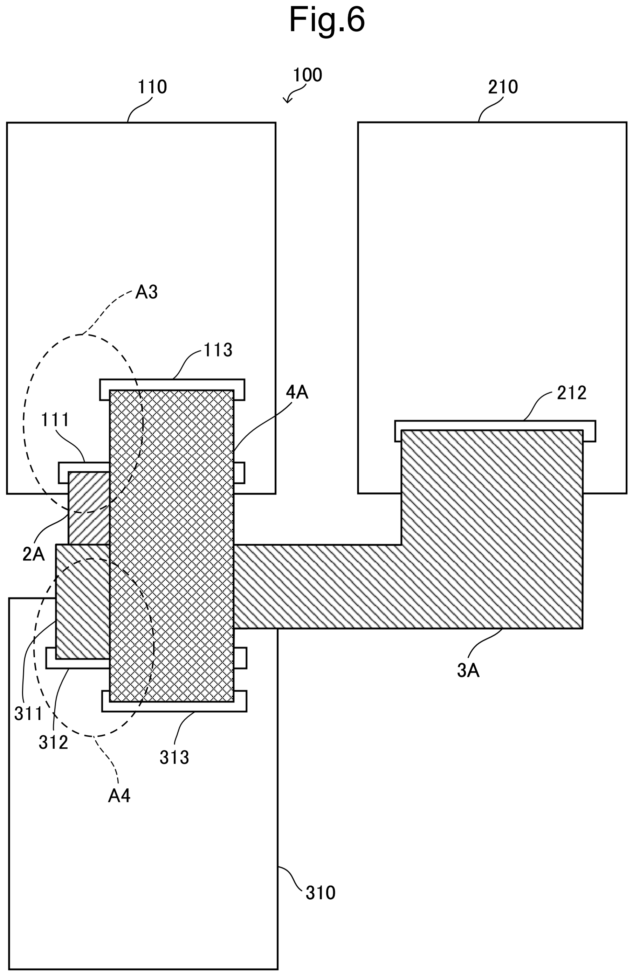

Subsequently, connection between the FFC connectors 111 and 113 of the board 110 in FIG. 5A and the FFC connectors 311 and 313 of the board 310 in FIG. 5C by FFCs 2A and 4A, and connection between the FFC connector 212 of the board 210 in FIG. 5B and the FFC connector 312 of the board 310 in FIG. 5C by an FFC 3A will be described with reference to FIG. 6. FIG. 6 is a schematic view showing a connection state by the FFCs 2A to 4A between the connectors 111 and 113 of the board 110 in FIG. 5A, the connector 212 of the board 210 in FIG. 5B, and the connectors 311 to 313 of the board 310 in FIG. 5C.

As shown in FIG. 6, a board unit 100 includes the board 110 having a planar shape and having the FFC connectors 111 and 113 disposed on one surface of the PWB 110A, the board 210 having a planar shape and having the FFC connector 212 disposed on the one surface of the PWB 210A, the board 310 having a planar shape and having the FFC connectors 311 to 313 disposed on the one surface of the PWB 310A, and the FFCs 2A to 4A connecting the FFC connectors 311 to 313 and the FFC connectors 111, 113, and 212 to each other.

The FFC 2A has the same number of conductors as the number of pins of the FFC connectors 111 and 311. In the FFC 2A, one ends of the plurality of conductors of the FFC 2A are connected to the plurality of pins of the connector 111, and the other ends thereof are connected to the plurality of pins of the connector 311. The FFC 3A has the same number of conductors as the number of pins of the FFC connectors 212 and 312. In the FFC 3A, one ends of the plurality of conductors of the FFC 3A are connected to the plurality of pins of the connector 212, and the other ends thereof are connected to the plurality of pins of the connector 312. The FFC 4A has the same number of conductors as the number of pins of the FFC connectors 113 and 313. In the FFC 4A, one ends of the plurality of conductors of the FFC 4A are connected to the plurality of pins of the connector 113, and the other ends thereof are connected to the plurality of pins of the connector 313 so as to straddle the FFC 3A.

According to the foregoing second embodiment, in a region surrounded by a dotted line A3 in FIG. 6, a portion of a connection part between the FFC connector 111 and the FFC 2A is visually recognizable from outside without being hidden by the FFCs 3A and 4A, and the entire connection part between the FFC connector 113 and the FFC 4A is visually recognizable from outside.

In addition, in a region surrounded by a dotted line A4 in FIG. 6, a portion of a connection part between the FFC connector 312 and the FFC 3A is visually recognizable from outside without being hidden by the FFC 4A, and the entire connection part between the FFC connector 313 and the FFC 4A is visually recognizable from outside. In addition, although the entire connection part between the FFC connector 311 and the FFC 2A is hidden by the FFC 3A, since one board 210 having the FFC 3A connected thereto differs from one board 110 having the FFCs 2A and 4A connected thereto, and the FFC 3A branches from the FFC group including the FFCs 2A and 4A, a portion of the FFC 2A is not hidden by the FFC 3A. Therefore, it is possible to improve visibility for confirming connection between the FFCs 2A to 4A and the FFC connectors 111, 113, 212, 312, and 313, and for confirming the presence of the FFC 2A during connection work and after connection work of the FFCs 2A to 4A to the FFC connectors 111, 113, 212, and 311 to 313.

The present invention is not limited to the configurations of the foregoing embodiments, and various modifications are possible.

For example, the second embodiment is directed to a case where the FFC connector 212 having one ends of conductors of the FFC 3A connected thereto is disposed on the board 210 different from the board 110 on which the FFC connectors 111 and 113 having one ends of conductors of the FFCs 2A and 4A connected thereto are disposed. However, the present invention is not limited thereto. For example, if the FFC 3A can branch from the FFC group including the FFCs 2A and 4A and at least a portion of the FFC 2A can be confirmed from outside, the FFC connector having the one ends of the conductors of the FFC 3A connected thereto may be disposed on the same board 110 as the FFC connectors 111 and 113.

Incidentally, it is desirable to be able to easily confirm connection of a plurality of FFCs to a plurality of connectors during connection work and after connection work of the plurality of FFCs to the plurality of connectors.

Each of the foregoing embodiments aims to improve visibility for confirming connection of cables such as a plurality of FFCs to a plurality of connectors during connection work and after connection work.

In addition, the configurations shown by the foregoing first embodiment using FIGS. 1A to 4, the configurations shown by the foregoing second embodiment using FIGS. 5A to 6, and the configurations shown by the foregoing modification examples are merely embodiments of the present invention, and the present invention is not intended to be limited by these configurations

## Claims

1. A board (10,310) having a planar shape and having N connectors (11~13, 311, 313) (N is an integer of 2 or larger) disposed on one surface thereof,
wherein each of the N connectors (11~13, 311, 313) includes a plurality of pins (11K) arranged in one direction, the number of the pins being different among the N connectors (11~13, 311, 313),
each of the N connectors (11~13, 311, 313) is disposed such that the one direction in which the plurality of pins (11K) are arranged is parallel to one side of the board (10, 310),
an nth connector having an nth largest number of pins (n is an integer of 2 to N) among the N connectors (11~13, 311, 313) is disposed between a straight line including one end in the one direction of an (n-1)th connector having an (n-1)th largest number of pins among the N connectors (11~13, 311, 313) and a straight line including the other end thereof in the one direction, and
the N connectors (11~13, 311, 313) are disposed such that the larger the number of the pins of connectors, the closer the connector is to the one side.

2. The board (10, 310) according to claim 1,
wherein the N connectors (11~13, 311, 313) are disposed side by side with one of the one ends and the other ends on a single straight line orthogonal to the one side.

3. The board (10, 310) according to claim 1,
wherein the N connectors (11~13, 311, 313) are connectors to which flexible flat cables (2~4, 2A, 4A) are connected.

4. The board (10, 310) according to claim 1,
wherein in each of the N connectors (11~13, 311, 313), intervals between the plurality of pins in a longitudinal direction are the same as each other.

5. A board unit (100) comprising:
the board (310) according to claim 1 serving as a first board;
a second board (110) different from the first board; and
a third board (210) different from the first board (310) and the second board (110),
wherein an additional connector (312) is further disposed on the one surface of the first board (310),
the additional connector (312) includes a plurality of pins arranged in one direction, the number of which is greater than the number of pins of an mth connector (311) having an mth largest number of pins (m is an integer from 1 to N) among the N connectors (311, 313),
the additional connector (312) is disposed farther from the one side than the mth connector,
N second board-side connectors (111, 113), to which the other ends of N flexible flat cables (2A, 4A) having one ends to be connected to the N connectors (311, 313) are connected, are disposed on the second board (110), and
a third board-side connector (212), to which the other end of a flexible flat cable (3A) having one end to be connected to the additional connector (312) is connected, is disposed on the third board (210).

6. The board unit (100) according to claim 5, further comprising:
a flexible flat cable (3A) having one end connected to the additional connector (312) disposed on the first board (310) and the other end connected to the third board-side connector (212) disposed on the third board (210).
